(19) Europäisches Patentamt
European Patent Office
Office européen des brevets

(11) Veröffentlichungsnummer: **0 117 543**
**A2**

(12) **EUROPÄISCHE PATENTANMELDUNG**

(21) Anmeldenummer: **84101940.9**

(51) Int. Cl.³: **H 03 K 3/03**

(22) Anmeldetag: **23.02.84**

(30) Priorität: **28.02.83 DE 3306939**

(43) Veröffentlichungstag der Anmeldung: **05.09.84 Patentblatt 84/36**

(84) Benannte Vertragsstaaten: **AT BE CH DE FR GB IT LI NL SE**

(71) Anmelder: **SIEMENS AKTIENGESELLSCHAFT, Berlin und München Wittelsbacherplatz 2, D-8000 München 2 (DE)**

(72) Erfinder: **Ringelhaan, Otmar, Dipl.-Ing., Mauthäuslstrasse 39, D-8000 München 70 (DE)**
Erfinder: **Weimert, Günter, Dipl.-Ing., Geisenbrunner Strasse 64, D-8000 München 71 (DE)**

(54) **Astabiler Multivibrator.**

(57) Zur empfangsseitigen Erzeugung von Taktsignalen bei der Übertragung digitaler Signale wird ein Rechteckgenerator benötigt, der bei geringem Aufwand ein phasensynchrones Rechtecksignal erzeugt. Zur Erzeugung von Rechtecksignalen ist die Verwendung von astabilen Multivibratoren bekannt. Entsprechend der Erfindung wird nun ein astabiler Multivibrator vorgeschlagen, der in Abhängigkeit von Eingangssignalen getriggert werden kann. Der erfindungsgemässe astabile Multivibrator enthält neben zwei flankengetriggerten monostabilen Multivibratoren, die als Ring geschaltet sind, ein Laufzeitglied. Die Anwendung erfolgt insbesondere bei der Übertragung digitaler Signale.

E
C1
R1
+Ub
R2
C2
Cl1
EX2
EX4
EX3
Cl2
A1
EX1
Q1
B1
MV1
Q̄1
A
T
A2
Q2
B2
MV2
Q̄2

EP 0 117 543 A2

SIEMENS AKTIENGESELLSCHAFT
Berlin und München



# Astabiler Multivibrator

Die Erfindung betrifft einen astabilen Multivibrator mit wenigstens einem Zeitglied und einem Signalausgang.

Bei der Decodierung digitaler Signale bzw. der Umcodierung von einem redundanten Code in beispielsweise den binären Code wird ein Taktsignal benötigt, mit dem die digitalen Signale in den Decoder bzw. Umcodierer eingelesen werden. Um zu erreichen, daß alle Zeichen des digitalen Signals zuverlässig übernommen werden, muß dieses Taktsignal der Zeitbasis des empfangenen digitalen Signals entsprechen und damit auch einem eventuellen Jitter, also Phasenschwankungen der Signalzeichen, folgen. Aus diesem Grund ist zur Taktableitung eine Phasenregelschleife ungeeignet, da bei hoher Güte die Phasenregelschleife den Phasenschwankungen nicht folgen kann und bei niedriger Güte ein unzulässig großer Phasenfehler entsteht.

Der Erfindung liegt die Aufgabe zugrunde, eine Möglichkeit zur Erzeugung eines Taktsignals zu schaffen, die wenig Aufwand erfordert und auch die Erzeugung von Taktsignalen bei der Übertragung digitaler Signale, die nach einem Code mit Lauflängenbegrenzung - beispielsweise dem bekannten HDB3-Code - gebildet wurden, zu schaffen.

Erfindungsgemäß wird die Aufgabe bei einem astabilen Multivibrator der eingangs erwähnten Art dadurch gelöst, daß flankengetriggerte monostabile Multivibratoren mit jeweils einem ersten und einem zweiten Signaleingang, einem Cleareingang, einem nichtinvertierenden und einem invertierenden Ausgang und zwei Anschlüssen für ein zugehöriges externes Zeitglied vorgesehen sind, daß diese Multivibratoren dadurch getriggert werden, daß jeweils am ersten Signaleingang eine negative Flanke oder jeweils am zweiten Signaleingang oder am Cleareingang eine positive Flanke anliegt, daß der erste Signaleingang des ersten Multivibrators mit Bezugspotential verbunden ist, daß die Cleareingänge des ersten und des zweiten Multivibrators miteinander und mit einem Triggereingang verbunden sind, daß der nichtinvertierende Ausgang des ersten Multivibrators mit dem ersten Signaleingang des zweiten Multivibrators direkt und über ein Laufzeitglied mit dem zweiten Signaleingang des zweiten Multivibrators verbunden ist, daß der invertierende Ausgang des zweiten Multivibrators mit dem zweiten Signaleingang des ersten Multivibrators verbunden ist, daß die Anschlüsse für das zugehörige externe Zeitglied des ersten und des zweiten Multivibrators jeweils getrennt über einen ersten bzw. zweiten Kondensator miteinander verbunden sind, daß jeweils einer der beiden Anschlüsse über einen ersten bzw. zweiten Widerstand mit einer Betriebsspannungsquelle verbunden sind und daß der invertierende Ausgang des ersten flankengetriggerten monostabilen Multivibrators den Ausgang des astabilen Multivibrators darstellt.

Der erfindungsgemäße astabile Multivibrator bietet besonders einfach die Möglichkeit, in integrierter Technik aufgebaut zu werden, da sowohl flankengetriggerte monostabile Multivibratoren als auch entsprechende Laufzeitglieder leicht in integrierter Technik herstellbar sind.

Zweckmäßige Weiterbildungen des erfindungsgemäßen astabilen Multivibrators sind in den Patentansprüchen 2 bis 5 beschrieben.

Die Erfindung soll im folgenden anhand der Zeichnung näher erläutert werden.

In der Zeichnung zeigt

Fig. 1 das Schaltbild eines astabilen Multivibrators nach der Erfindung,

Fig. 2 die Funktionstabelle der im astabilten Multivibrator nach der Fig. 1 enthaltenen monostabilen Multivibratoren,

Fig. 3 ein Impulsdiagramm zum astabilen Multivibrator nach der Fig. 1.

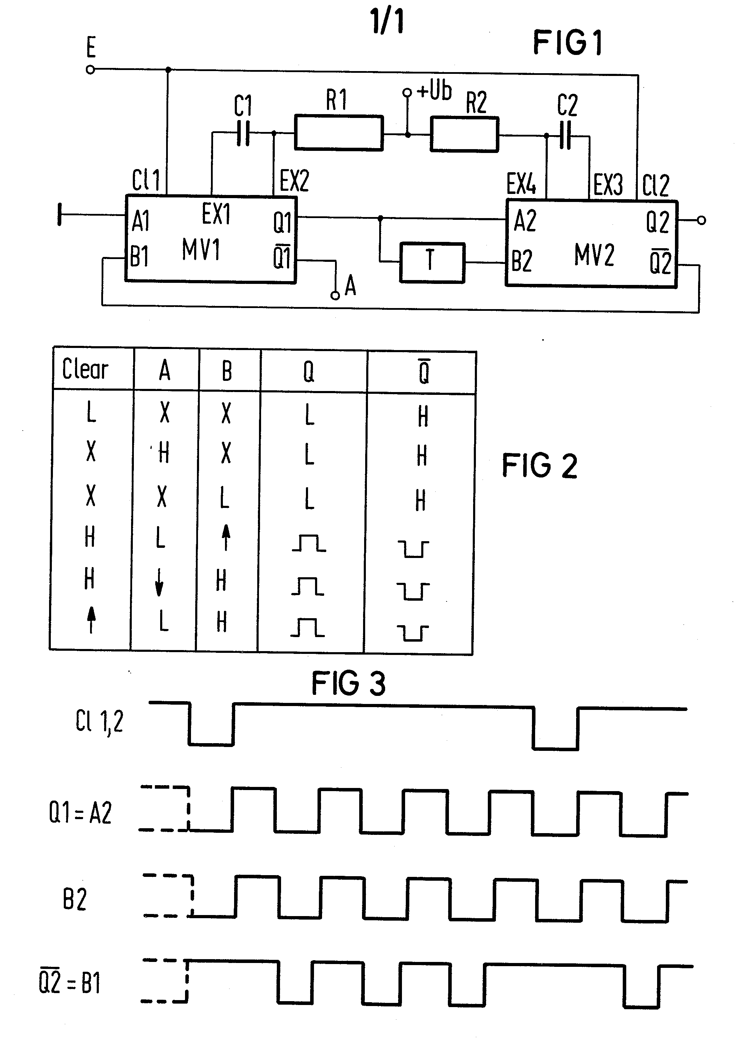

In der Fig. 1 sind mit MV1 und MV2 der erste und der zweite flankengetriggerte monostabile Multivibrator bezeichnet, die zusammen mit dem Laufzeitglied T und den beiden zu den Multivibratoren MV1, MV2 gehörigen Zeitgliedern aus dem ersten Kondensator C1 und dem ersten Widerstand R1 bzw. dem zweiten Kondensator C2 und dem zweiten Widerstand R2 den astabilen Multivibrator bilden. Der erste Signaleingang A1 des ersten Multivibrators MV1 ist dabei mit Bezugspotential verbunden, der zweite Signaleingang B1 dieses Multivibrators ist an den invertierenden Ausgang $\overline{Q}2$ des zweiten Multivibrators MV2 angeschlossen. Mit dem nichtinvertierenden Ausgang Q1 des ersten Multivibrators ist direkt der erste Signaleingang A2 und über ein Laufzeitglied T mit einer Laufzeit von wenigstens einer Gatterlaufzeit der verwendeten Multivibratoren der zweite Signaleingang B2 des zweiten Multivibrators verbunden. Die Clear- bzw. Löscheingänge der beiden Multivibratoren sind miteinander und mit einem Triggereingang E verbunden, über den die Abgabe von Rechteckimpulsen über den invertierenden Ausgang $\overline{Q}1$ des ersten Multivibrators bzw. den Ausgang A des astabilen Multivibrators ausgelöst wird. Die Folgefrequenz der erzeugten Impulse wird durch die beiden einander gleichen Zeitglieder bestimmt, wobei der erste Kondensator C1 die beiden Anschlüsse EX1 und EX2 des ersten Multivibrators miteinander verbindet, während der erste Widerstand R1 dem dafür vorgesehenen Anschluß EX2 mit der positiven Betriebsspannung verbindet. Analog ist der zweite Multivibrator MV2 geschaltet, bei dem der zweite Kondensator C2 die beiden Anschlüsse EX3, EX4 für ein externes Zeitglied miteinander verbindet, und der zweite Widerstand R2 den Anschluß EX4 mit der positiven Betriebsspannungsquelle +Ub verbindet. Die Wirkungsweise des ersten und des zweiten Multivibrators MV1, MV2 läßt sich aus der in der Fig. 2 dargestellten Funktionstabelle erkennen. In der Funktionstabelle ist mit L der niedrige Logikpegel, mit H der hohe Logikpegel und mit X ein beliebiger Logikpegel bezeichnet, während Pfeile nach unten bzw. oben die ab- bzw. ansteigende Flanke eines Impulses bezeichnen. Aus der Funktionstabelle ist erkennbar, daß die monostabilen Multivibratoren MV1 bzw. MV2 getriggert werden, also ein Impuls ausgelöst wird: durch eine negative Impulsflanke am ersten Eingang A, sofern der zweite Eingang B und der Cleareingang auf hohem Potential sind, durch eine positive Flanke am zweiten Eingang B, sofern der erste Eingang A auf niedrigem und der Cleareingang auf hohem Potential sind oder durch eine positive Flanke am Cleareingang, sofern der erste Eingang A auf niedrigem und der zweite Eingang B auf hohem Potential sind. Zur Erläuterung der Wirkungsweise des astabilen Multivibrators nach der Fig. 1 wird das Impulsdiagramm nach der Fig. 3 herangezogen.

In der oberen, mit Cl1,2 bezeichneten Zeile sind die am Triggereingang E ankommenden Nachrichten-Impulse dargestellt, die als negative RZ-Impulse vorliegen. Zwischen diesen Impulsen liegt hier eine Pause, die mehrere Bitperioden andauert, und während der ebenfalls ein Taktsignal erzeugt werden soll. Ein negativer Eingangsimpuls entsprechend der obersten Zeile der Fig. 3 erzeugt am nichtinvertierenden Ausgang Q1 des ersten Multivibrators niedriges Potential und hohes Potential am invertierenden Ausgang $\overline{Q}2$ des zweiten Multivibrators. Durch die positive Rückflanke des Eingangsimpulses wird über den zweiten Eingang B1 der erste monostabile Multivibrator MV1 getriggert. Dadurch geht zuerst das Potential am ersten Eingang A2 des zweiten Multivibrators MV2 und anschließend das Potential an dessen zweitem Eingang B2 hoch, ohne daß durch diesen Vorgang der zweite Multivibrator getriggert wird. Erst durch die negative Rückflanke des Ausgangsimpulses des nichtinvertierenden Ausganges Q1 des ersten Multivibrators, die vom Eingang A2 des zweiten Multivibrators aufgenommen wird, wird der zweite Multivibrator getriggert, ohne daß der erste Multivibrator bei diesem Vorgang getriggert wird. Durch die positive Rückflanke des Ausgangsimpulses des invertierenden Ausganges $\overline{Q}2$ des zweiten Multivibrators wird über den zweiten Eingang B1 der erste Multivibrator getriggert, dessen Ausgangsimpuls wiederum den zweiten Multivibrator triggert und dadurch die Erzeugung eines Rechteckwellenimpulszuges auslöst. Es entsteht dadurch ein Taktsignal, das bei entsprechender Bemessung der beiden Zeitglieder etwa der Zeitbasis der Eingangsimpulse entspricht und an einem der Ausgänge der Multivibratoren, beispielsweise am invertierende Ausgang Q1 des ersten Multivibrators abgenommen werden kann.

Der Phasenfehler zwischen dem erzeugten Taktsignal und den Eingangsimpulsen kann während des Betriebes nicht über ein bestimmtes zulässiges Maß anwachsen, da jeder negative Eingangsimpuls zu einer erneuten Triggerung und damit zu einer Zwangssynchronisation des astabilen Multivibrators führt. Der beschriebene astabile Multivibrator ist damit nicht nur als gesteuerter Taktregenerator bei der Übertragung digitaler Signale sondern auch als gesteuerter und synchronisierter Rechteckwellengenerator für ferngesteuerte Einrichtungen vorteilhaft verwendbar.

5 Patentansprüche

3 Figuren

Patentansprüche

1. Astabiler Multivibrator mit wenigstens einem Zeitglied und einem Signalausgang, dadurch gekennzeichnet, daß zwei flankengetriggerte monostabile Multivibratoren (MV1, MV2) mit jeweils einem ersten und einem zweiten Signaleingang (A1, A2, B1, B2), einem Cleareingang (Cl1, Cl2), einem nichtinvertierenden und einem invertierenden Ausgang (Q1, Q2, $\overline{Q}1$, $\overline{Q}2$) und zwei Anschlüssen (EX1, EX2, EX3, EX4) für ein zugehöriges externes Zeitglied vorgesehen sind, daß diese Multivibratoren dadurch getriggert werden, daß jeweils am ersten Signaleingang (A1, B1) eine negative Flanke oder jeweils am zweiten Signaleingang (A2, B2) oder am Cleareingang (Cl1, Cl2) eine positive Flanke anliegt, daß der erste Signaleingang (A1) des ersten Multivibrators (MV1) mit Bezugspotential verbunden ist, daß die Cleareingänge (Cl1, Cl2) des ersten und des zweiten Multivibrators (MV1, MV2) miteinander und mit einem Triggereingang (E) verbunden sind, daß der nichtinvertierende Ausgang (Q1) des ersten Multivibrators (MV1) mit dem ersten Signaleingang (A2) des zweiten Multivibrators MV2) direkt und über ein Laufzeitglied (T) mit dem zweiten Signaleingang (B2) des zweiten Multivibrators verbunden ist, daß der invertierende Ausgang ($\overline{Q}2$) des zweiten Multivibrators mit dem zweiten Signaleingang (B1) des ersten Multivibrators verbunden ist, daß die Anschlüsse (EX1, EX2; EX3, EX4) für das zugehörige externe Zeitglied des ersten und des zweiten Multivibrators (MV1, MV2) jeweils getrennt über einen ersten bzw. zweiten Kondensator (C1, C2) miteinander verbunden sind, daß jeweils einer der beiden Anschlüsse (EX1, EX2; EX3, EX4) über einen ersten bzw. zweiten Widerstand (R1, R2) mit einer Betriebsspannungsquelle (+Ub) verbunden sind und daß der invertierende Ausgang ($\overline{Q}1$) des ersten flankengetriggerten monostabilen Multivibrators (MV1) den Ausgang (A) des astabilen Multivibrators darstellt.

2. Astabiler Multivibrator nach Patentanspruch 1, d a - d u r c h g e k e n n z e i c h n e t , daß ein von dem ersten oder zweiten monostabilen Multivibrator (MV1, MV2) erzeugter Impuls dadurch vorzeitig beendet wird, daß an den Cleareingang des betreffenden monostabilen Multivibrators Null-Potential angelegt ist.

3. Astabiler Multivibrator nach Patentanspruch 1, d a - d u r c h g e k e n n z e i c h n e t , daß das Laufzeitglied (T) eine Verzögerung von wenigstens einer Gatterlaufzeit der Multivibratoren aufweist.

4. Astabiler Multivibrator nach Patentanspruch 1, d a - d u r c h g e k e n n z e i c h n e t , daß am Triggereingang (E) das digitale Signal in Form negativer RZ-Impulse anliegt.

5. Astabiler Multivibrator nach Patentansprüchen 1 bis 4, d a d u r c h g e k e n n z e i c h n e t , durch seine Verwendung als getriggerter Taktgenerator bei der Übertragung digitaler Signale.

FIG 1

E
C1
R1
+Ub
R2
C2
Cl1
EX2
EX4
EX3
Cl2
A1
EX1
Q1
MV1
B1
$\overline{Q1}$
A
T
A2
Q2
B2
MV2
$\overline{Q2}$

| Clear | A | B | Q | $\overline{Q}$ |
|---|---|---|---|---|
| L | X | X | L | H |
| X | H | X | L | H |
| X | X | L | L | H |
| H | L | ↑ | ⊓ | ⊔ |
| H | ↓ | H | ⊓ | ⊔ |
| ↑ | L | H | ⊓ | ⊔ |

FIG 2

FIG 3

Cl 1,2
Q1 = A2
B2
$\overline{Q2}$ = B1